# EUROPÄISCHE PATENTSCHRIFT

(11) **EP 1 474 808 B1**
(45) Veröffentlichungstag und Bekanntmachung des Hinweises auf die Patenterteilung: **09.11.2005**
(21) Anmeldenummer: 03704264.5
(22) Anmeldetag: 28.01.2003
(51) Int. Cl.: G11C 16/22

(54) **EEPROM-SPEICHERMATRIX UND VERFAHREN ZUR ABSICHERUNG EINER EEPROM-SPEICHERMATRIX**
EEPROM MEMORY MATRIX AND METHOD FOR PROTECTING AN EEPROM MEMORY MATRIX
MATRICE DE MEMOIRE EEPROM ET PROCEDE POUR PROTEGER CETTE DERNIERE

(30) Priorität: 14.02.2002 DE 10206186
(43) Veröffentlichungstag der Anmeldung: 10.11.2004
(73) Patentinhaber: Infineon Technologies AG, 81669 München (DE)
(72) Erfinder: GAMPERL, Susanne, 82293 Vogach (DE); TSCHETERNIGG, Siegfried, 86946 Vilgertshofen (DE); WEDEL, Armin, 86415 Mering (DE)
(74) Vertreter: Epping - Hermann - Fischer
(86) Internationale Anmeldenummer: PCT/DE2003/000224
(87) Internationale Veröffentlichungsnummer: WO 2003/069629

(56) Entgegenhaltungen:
- EP-A- 0 479 461
- EP-A- 0 776 012
- US-A- 6 058 044

## Beschreibung

Die vorliegende Erfindung betrifft eine EEPROM-Speichermatrix und ein Verfahren, mit dem es möglich ist, die Speichermatrix gegen Lichtangriffe abzusichern.

Die Funktion von integrierten Halbleiterschaltkreisen kann durch Einwirkung von Licht beeinflusst werden. An pn-Übergängen führt die eingestrahlte Photonenenergie zur Erzeugung von Elektron-Loch-Paaren, die in einem geschlossenen Stromkreis zu einem Stromfluss führen. Beim Anlegen einer Spannung an einen pn-Übergang in Sperrrichtung fließt ohne Lichteinstrahlung ein Leckstrom, der so genannte Dunkelstrom, der sehr klein ist. Bei Lichteinstrahlung wird dem Dunkelstrom ein von der Lichtintensität abhängiger und wesentlich stärkerer Photostrom überlagert.

In manchen sicherheitsrelevanten IC-Chips (z. B. Security Memory ICs) werden Leitungen, auf denen geheime Daten übertragen werden, innerhalb des Halbleitermaterials in Diffusionsebenen angeordnet, weil man dadurch einen guten Schutz gegen physikalische Angriffe (z. B. Probing mittels aufgesetzter Kontaktnadeln) erzielt. Diese Leitungen sind daher in dem Halbleitermaterial als streifenförmige dotierte Bereiche ausgebildet. An den Außenwandungen dieser Diffusionsbahnen sind zum Substrat bzw. zu einer dotierten Wanne in dem Substrat hin pn-Übergänge vorhanden, die im Normalbetrieb der Schaltung in Sperrrichtung gepolt sind. Bei Lichteinfall treten an diesen pn-Übergängen Leckströme auf, die den Spannungspegel auf der Leitung beeinflussen, insbesondere wenn dort ein dynamisches (kapazitives) Datensignal geführt wird. Es können daraufhin geeignete Maßnahmen eingeleitet werden, falls die Datenübertragung durch den Spannungsabfall nicht ohnehin für den Angreifer unkenntlich geworden ist.

Schädliche Auswirkungen von Lichtangriffen auf sicherheitsrelevante Schaltungsteile lassen sich am ehesten vermeiden, wenn ein Lichtdetektor auf dem IC-Chip vorhanden ist. Allerdings ist es nicht ausreichend, wenn ein solcher Lichtdetektor örtlich begrenzt angeordnet ist, da ein Lichtstrahl auch auf sicherheitskritische Schaltkreise fokussiert werden kann. Daher ist es notwendig, den Lichtdetektor so auszugestalten, dass er flächig über die integrierte Schaltung verteilt ist und überall dort einsatzbereit ist, wo die kritischen Stellen des Schaltkreises angeordnet sind. Streng genommen müsste ein wirksamer Lichtdetektor genau am Platz der zu schützenden Schaltungsteile angebracht sein. Weil sich jedoch in der Regel über dem zu schützenden Schaltungsteil Leitungen der Verdrahtung der Schaltung in verschiedenen Metallisierungsebenen befinden, kommt es zu Beugungseffekten und Streueffekten des Lichtes, die eine sehr eng begrenzte Fokussierung des Lichtstrahls zunichte machen, so dass es ausreicht, eine Lichtdetektorstruktur wenigstens einigermaßen in der Nähe der zu schützenden Schaltungsteile anzuordnen.

Bei der Absicherung einer EEPROM-Speichermatrix gegen Lichtangriffe tritt das Problem auf, dass die für das Auslesen sicherheitskritischer Daten vorgesehenen Leitungen einen vergleichsweise großen Flächenbereich überdecken, so dass dort überall Lichtdetektorstrukturen vorhanden sein müssen. Lichtdetektorstrukturen, die in die Anordnung der Speicherzellen einer EEPROM-Speichermatrix integriert sind, erhöhen jedoch den von der Speichermatrix beanspruchten Flächenbedarf erheblich.

Während die EP 0 776 012 sowie die US 6 058 044 EEPROM-Speichermatrizen ohne Alarmfunktion gegen Lichtangriffe betreffen, weist die aus der EP 0 479 461 bekannte Speichermatrix einen von den Spaltenleitungen unabhängigen Lichtdetektor auf.

Aufgabe der vorliegenden Erfindung ist es, eine wirkungsvolle Absicherung einer EEPROM-Speichermatrix gegen Lichtangriffe anzugeben, die den auf dem IC-Chip erforderlichen Platzbedarf nicht oder allenfalls unwesentlich erhöht.

Diese Aufgabe wird mit der EEPROM-Speichermatrix mit den Merkmalen des Anspruches 1 bzw. mit dem Verfahren zur Absicherung einer EEPROM-Speichermatrix mit den Merkmalen des Anspruches 4 gelöst. Ausgestaltungen ergeben sich aus den abhängigen Ansprüchen.

Es ist möglich, einen Lichtdetektor so im Layout der Schaltung der Speichermatrix zu integrieren, dass er einen Lichtangriff entlang einer signalführenden Diffusionsleitung detektiert. Als geeignet zur Ausbildung eines solchen Lichtdetektors erscheint eine parallel zu der zu schützenden Datenleitung geführte weitere Diffusionsleitung, die während definierter Taktphasen, in denen geheime Daten übermittelt werden, mit einer Precharge-Spannung beaufschlagt wird. Ein an diese Detektorleitungen angeschlossenes Logikgatter, das den Spannungspegel der Lichtdetektorleitung während der entsprechenden Taktphase auswertet, gibt ein Alarmsignal ab oder löst eine sonstige Alarmfunktion aus, wenn die Spannung auf der Detektorleitung auf einen zu niedrigen Pegel abfällt. Mit einer solchen Anordnung erzielt man einen ausreichenden Schutz gegen Lichtangriffe entlang der sicherheitskritischen Datenleitungen.

Erfindungsgemäß werden die zum Auslesen der Speicherzellen ohnehin vorhandenen Spaltenleitungen der EEPROM-Speichermatrix alternativ als Detektorleitungen eingesetzt. Da die EEPROM-Speichermatrix eine Flächenausdehnung aufweist, die einen flächig ausgedehnten Schutz gegen Lichtangriffe erforderlich macht, werden vorzugsweise zu den jeweils für die Datenübertragung ausgewählten Spaltenleitungen benachbarte Spaltenleitungen als Detektorleitungen geschaltet, um damit die Datenübertragung gegen Lichtangriffe abzusichern. Diese als Detektorleitungen ausgewählten Spaltenleitungen werden jeweils vor dem Auslesen der betreffenden Speicherspalte zusammen mit der zu lesenden Spaltenleitung mit der Precharge-Spannung beaufschlagt. Wenn die Detektorspaltenleitungen ihre Precharge-Level während des Auslesens der Speicherzellen verlieren, wird von einem Lichteinfall ausgegangen und eine entsprechende Alarmfunktion ausgelöst. Zu diesem Zweck ist eine Auswerteeinheit vorhanden, die z. B. ein Logikgatter umfasst, dem die auszuwertenden Spannungen zugeführt werden.

Bei einem Teil der Security-ICs ist es üblich, Daten seriell auszulesen. Deshalb können in einer entsprechenden Anordnung der Speicherzellen in einer Speichermatrix alle Spaltenleitungen mit Ausnahme der jeweils auszulesenden Spalte als Detektorleitungen verwendet werden. In der Auswerteeinheit wird jeweils die Spaltenleitung derjenigen Speicherspalte von der Auswertung ausgenommen, die gerade ausgelesen wird. Werden Daten parallel ausgelesen, ist es notwendig, die Spalten der Speichermatrix so zu adressieren, dass in der Speicherzellenadresse benachbarte Spalten nicht physikalisch nebeneinander liegen, sondern dass sich ein Nebeneinander von Spaltenleitungen der zu lesenden Spalten und Detektorspaltenleitungen ergibt.

In den beigefügten Figuren sind zwei Schaltungsschemata als Beispiele dargestellt.

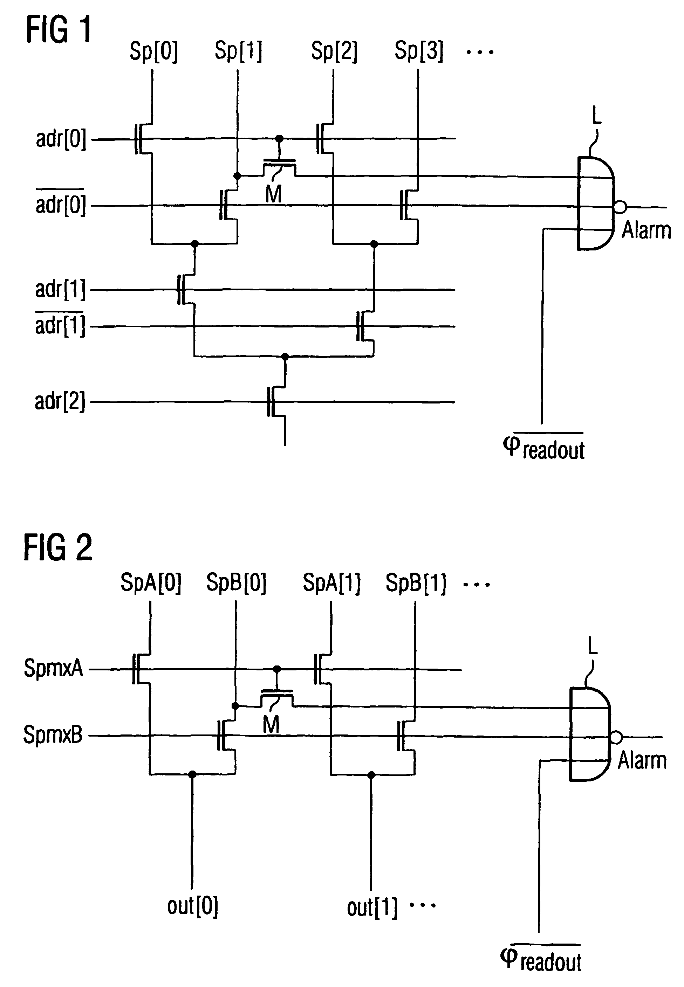

In der Figur 1 ist ein Schaltungsschema für einen seriellen Spaltendecoder mit Spaltenleitungen Sp[0], Sp[1], Sp[2], Sp[3], ... , Adressleitungen adr[0], adr[1], adr[2], ... und komplementären Adressleitungen dargestellt. Zu jeder geradzahlig nummerierten Spalte, die ausgelesen wird, werden die ungeradzahligen Spalten als Detektorleitungen geschaltet. Dazu ist jeweils ein Schalttransistor als Schalter M vorhanden, der, wenn er geschlossen, also durchlässig ist, die betreffende ungeradzahlig nummerierte Spalte auf ein Logikgatter L schaltet. Die Schalttransistoren, die die ungeradzahlig nummerierten Spalten in diesem Beispiel mit einem NOR-Gatter L verbinden, werden in diesem Beispiel von der Adressleitung adr[0] geschlossen; grundsätzlich kann aber eine beliebige Adressleitung, die bei geraden Adressen auf "high" steht, mit den Gate-Anschlüssen der Schalter M verbunden sein.

Die Schalter M, von denen in der Figur 1 nur der erste eingezeichnet ist, verbinden bei hohem. Pegel auf adr[0] die betreffende Spalte, hier die Spalte Sp[1] im Beispiel des eingezeichneten Schalters, mit dem Logikgatter L, so dass dort zumindest ein Eingang auf dem hohen Precharge-Level liegt. An einem weiteren Eingang des Logikgatters L liegt die zu adr[0] komplementäre Leitung, also ein niedriger Pegel. Während des Auslesens des Speichers ist ein entsprechendes Taktsignal ϕ_{readout} auf hohem Pegel. Das dazu komplementäre Taktsignal, also ein niedriger Pegel, ist ebenfalls auf einen Eingang des NOR-Gatters gelegt, so dass an dessen Ausgang während des Auslesens des Speichers nur dann ein hoher Pegel vorhanden ist, wenn ein fehlerhaft niedriger Pegel von einer der ungeraden Spaltenleitungen, das heißt, von einer der Detektorleitungen, zugeführt wird. In diesem Fall wird davon ausgegangen, dass dieser niedrige Pegel auf der Detektorleitung von einer Lichteinstrahlung herrührt, und ein für diesen Fall vorgesehener Alarm gegeben.

In dem Beispiel der Figur 1 sind die Spaltendecodertransistoren als NMOS-Transistoren ausgeführt. Damit man beim Durchschalten der Spannungspegel keinen Pegelverlust erleidet, werden diese Transistoren mit einem überhöhten Spannungspegel in den Adressleitungen angesteuert. Im Hinblick auf ein Schaltungsdesign, das gegen Manipulationen sicher ist, wird die Zuleitung von der Spalte zu dem Schalttransistor M in derselben Schicht angeordnet wie die Spaltenleitungen. Die Leitung zu dem Logikgatter kann in einer anderen Schichtlage angeordnet sein; sie sollte jedoch mit einem Shield versehen sein, um diese Leitung gegen unbefugten Zugriff zu schützen.

Die Figur 2 zeigt entsprechend ein Schaltungsschema eines parallelen Spaltendecoders. Auch hier ist zu jeder Spaltenleitung SpB[0], SpB[1], SpB[2], SpB[3], ... , die beim parallelen Auslesen des_Speichers über die Spaltenleitungen SpA[0], SpA[1], SpA[2], SpA[3], ... als Detektorleitung fungiert, ein entsprechender Schalttransistor als Schalter M vorgesehen. Die Schalter M werden über die Adressleitung SpmxA geschlossen, wenn diese einen hohen Pegel besitzt, um die Spaltenleitungen SpA[0], SpA[1], SpA[2], SpA[3], ... mit den Ausgängen out[0], out[1], out[2], ... zu verbinden. Die geschlossenen Schalter M verbinden die aktuellen Detektorleitungen SpB[0], SpB[1], SpB[2], SpB[3], ... mit dem NOR-Gatter L. Die in der Figur 2 gezeigte Schaltung arbeitet ansonsten entsprechend der Schaltung der Figur 1.

Erfindungsgemäß ergibt sich daher eine flächenoptimale Lösung der gestellten Aufgabe für eine EEPROM-Speichermatrix mit integriertem Lichtdetektor. Gegenüber einer herkömmlichen Speichermatrix ist es lediglich notwendig, einen Detektorschaltkreis vorzusehen, der die Spaltenleitungen der jeweils nicht zu lesenden Spalten während des Auslesevorganges auf ihren Precharge-Level hin auswertet.

### Bezugszeichenliste

- L: Logikgatter
- M: Schalter
- Sp[k]: Spaltenleitung
- SpA[k]: Spaltenleitung
- SpB[k]: Spaltenleitung
- SpmxA: Adressleitung
- SpmxB: Adressleitung
- adr[k]: Adressleitung

## Patentansprüche

1. EEPROM-Speichermatrix mit
einer matrixartigen Anordnung von Speicherzellen, Spaltenleitungen (Sp[k]; SpA[k], SpB[k]) und
Adressleitungen (adr[k]; SpmxA, SpmxB), bei der Mittel vorgesehen sind, mit denen Spaltenleitungen auf einen Precharge-Level gebracht werden, und
Schalter (M) vorgesehen sind, mit denen Spaltenleitungen mit einer Auswerteeinheit verbunden werden,
**dadurch gekennzeichnet, dass**
zum Schutz gegen Lichtangriffe vorgesehen ist, Spaltenleitungen, die jeweils nicht zum Auslesen von Speicherzellen eingesetzt werden, als Detektorleitungen einzusetzen und auf einen Precharge-Level zu bringen und
die Detektorleitungen mittels der Schalter (M) mit der Auswerteeinheit zu verbinden, mit der eine Alarmfunktion ausgelöst wird, wenn die Detektorleitungen bei einem Lichteinfall ihre Precharge-Level verlieren.

2. EEPROM-Speichermatrix nach Anspruch 1, bei der
die Speicherzellen für ein serielles Auslesen vorgesehen sind und
Schalter vorhanden sind, mit denen alle Spaltenleitungen mit Ausnahme einer für das jeweilige Auslesen ausgewählten Spaltenleitung als Detektorleitungen geschaltet werden können.

3. EEPROM-Speichermatrix nach Anspruch 1, bei der
die Speicherzellen für ein paralleles Auslesen vorgesehen sind und
Schalter vorhanden sind, mit denen ein Teil der Spaltenleitungen für das Auslesen ausgewählt und ein Teil der Spaltenleitungen als Detektorleitungen geschaltet werden können, derart, dass Spaltenleitungen der auszulesenden Spalten und Detektorleitungen nebeneinander angeordnet sind.

4. Verfahren zur Absicherung einer EEPROM-Speichermatrix mit einer matrixartigen Anordnung von Speicherzellen, Spaltenleitungen (Sp[k]; SpA[k], SpB[k]) und Adressleitungen (adr[k]; SpmxA, SpmxB) gegen Lichtangriffe,
**dadurch gekennzeichnet, dass**
Spaltenleitungen als Detektorleitungen ausgewählt und mit einer Precharge-Spannung beaufschlagt werden und
während eines Auslesens von Speicherzellen über andere Spaltenleitungen die Spannungspegel auf den Detektorleitungen überprüft und bei einem Absinken eines Spannungspegels eine Alarmfunktion ausgelöst wird.

## Claims

1. EEPROM memory matrix having
a matrix-like arrangement of memory cells,
column lines (Sp[k]; SpA[k], SpB[k]) and
address lines (adr[k]; SpmxA, SpmxB), in which
means are provided in which column lines are brought to a precharge level, and
switches (M) are provided by which column lines are connected to an evaluation unit,
**characterized in that**
for protection against light attacks, provision is made for using column lines that are in each case not used for the read-out of memory cells as detector lines and for bringing them to a precharge level, and
for connecting the detector lines to the evaluation unit by means of the switches (M), said evaluation unit triggering an alarm function if the detector lines lose their precharge levels in the event of light incidence.

2. EEPROM memory matrix according to Claim 1, in which
the memory cells are provided for a serial read-out and switches are present by means of which all the column lines with the exception of a column line selected for the respective read-out can be connected as detector lines.

3. EEPROM memory matrix according to Claim 1, in which
the memory cells are provided for a parallel read-out and
switches are present by means of which some of the column lines can be selected for the read-out and some of the column lines can be connected as detector lines, in such a way that column lines of the columns to be read out and detector lines are arranged next to one another.

4. Method for safeguarding an EEPROM memory matrix having a matrix-like arrangement of memory cells, column lines (Sp[k]; SpA[k], SpB[k]) and address lines (adr[k]; SpmxA, SpmxB) against light attacks,
**Characterized in that**
column lines are selected as detector lines and have a precharge voltage applied to them, and
during a read-out of memory cells via other column lines, the voltage levels on the detector lines are checked and an alarm function is triggered when a voltage level falls.

## Revendications

1. Matrice de mémoire EEPROM comprenant
une configuration en matrice de cellules de mémoire,
des lignes (Sp[k] ; SpA[k], SpB[k]) de colonne et
des lignes (adr[k] ; ApmxA, SpmxB) d'adresse, dans laquelle
il est prévu des moyens par lesquels les lignes de colonne peuvent être portées à un niveau de précharge et
il est prévu des commutateurs (M) par lesquels des lignes de colonne sont reliées à une unité d'exploitation,
**caractérisée en ce que**,
il est prévu, pour se protéger des effets de la lumière, d'utiliser des lignes de colonne qui ne sont pas utilisées pour la lecture de cellules de mémoire comme lignes de détecteur et de les porter à un niveau de précharge et
de relier les détecteurs au moyen des commutateurs (M) à l'unité d'exploitation par laquelle une fonction d'alerte est déclenchée si les lignes de détecteur perdent leur niveau de précharge par de la lumière incidente.

2. Matrice de mémoire EEPROM suivant la revendication 1, dans laquelle
les cellules de mémoire sont prévues pour une lecture séquentielle et
il y a des commutateurs par lesquels toutes les lignes de colonne, à l'exception d'une ligne de colonnes sélectionnée pour la lecture, peuvent être montées en lignes de détecteur.

3. Matrice de mémoire EEPROM suivant la revendication 1, dans laquelle
les cellules de mémoire sont prévues pour une lecture en parallèle et
il y a des commutateurs par lesquels une partie des lignes de colonne est sélectionnée pour la lecture et une partie des lignes de colonne peut être montée en lignes de détecteur, de façon à ce que des lignes de colonne parmi les colonnes à lire et des lignes de détecteur soient disposées côte à côte.

4. Procédé de protection d'une matrice de mémoire EEPROM ayant une configuration en matrice de cellules de mémoire, de lignes (Sp[k] ; SpA[k], SpB[k]) de colonnes et de lignes (adr[k] ; ApmxA, SpmxB) d'adresse de l'action de la lumière,
**caractérisé en ce que** l'on sélectionne des lignes de colonne comme lignes de détecteur et on les charge par une tension de précharge et, pendant une lecture de cellules de mémoire par d'autres lignes de colonne, on contrôle le niveau de la tension sur les lignes de détecteur et si un niveau de tension s'abaisse, on déclenche une fonction d'alerte.
